Europäisches Patentamt

(19) European Patent Office

Office européen des brevets

(11) Veröffentlichungsnummer: **0 394 327 B1**

(12) **EUROPÄISCHE PATENTSCHRIFT**

(45) Veröffentlichungstag der Patentschrift:
06.11.91 Patentblatt 91/45

(51) Int. Cl.⁵: **B60R 16/02**

(21) Anmeldenummer: 89900793.4

(22) Anmeldetag: 30.12.88

(86) Internationale Anmeldenummer:
PCT/DE88/00783

(87) Internationale Veröffentlichungsnummer:
WO 89/06201 13.07.89 Gazette 89/15

(54) **ZENTRALELEKTRIK FÜR KRAFTFAHRZEUGE.**

(30) Priorität: 31.12.87 DE 3744603
27.12.88 DE 3843972

(43) Veröffentlichungstag der Anmeldung:
31.10.90 Patentblatt 90/44

(45) Bekanntmachung des Hinweises auf die
Patenterteilung:
06.11.91 Patentblatt 91/45

(84) Benannte Vertragsstaaten:
DE FR GB IT

(56) Entgegenhaltungen:
EP-A- 0 240 453
DE-A- 3 439 410
DE-A- 3 525 085
DE-B- 2 836 166
DE-C- 3 048 451
DE-C- 3 608 752
IBM TECHNICAL DISCLOSURES BULLETIN;
Vol. 25, No. 4, September 1982, R.F. Kilburn
and R.F. Olsen: "PRINTED CIRCUIT MODULE
ASSEMBLY", see page 1803

(73) Patentinhaber: FRANZ KIRSTEN
ELEKTROTECHNISCHE SPEZIALFABRIK
Franz Kirsten Strasse 1
W-6530 Bingen-Bingerbrück (DE)

(72) Erfinder: KOBOLD, Ulrich
Am Hahn 18
W-6534 Stromberg (DE)
Erfinder: KUHN, Heinz, J.
Berliner Strasse 15
W-6531 Waldalgesheim (DE)
Erfinder: BUTZBACH, Karl, F.
An der Kirchenpforte 6
W-6550 Bad Kreuznach (DE)
Erfinder: HILL, Manfred
Am Schwimmbad 33
W-6530 Bingen (DE)

(74) Vertreter: Becker, Bernd, Dipl.-Ing.
Hauptstrasse 10
W-6530 Bingen 17 (DE)

## Beschreibung

Die Erfindung bezieht sich auf eine Zentralelektrik für Kraftfahrzeuge zum zentralen Anschluß elektrischer bauteile, wie Sicherungen, Schaltgeräte, elektronische Steuerungen für elektrische Verbraucher und dergleichen, mit einem plattenartig geschichteten Leiterpaket, das in verschiedenen Ebenen übereinander angeordnete, durch Isolierplatten voneinander getrennte Flachleiterplatten aufweist.

Eine solche Zentralelektrik erfüllt im wesentlichen eine Verteilerfunktion, um die elektrischen Verbraucher des Kraftfahrzeuges, wie z.b. Lampen, Scheibenwischer, Blinker und dergleichen, über Leiterstränge bzw. Kabelbäume mit elektrischer Spannung zu versorgen, die Funktionstüchtigkeit der Verbraucher zu überwachen und etwaige Fehler zu ermitteln und anzuzeigen und gegebenenfalls fehlerhafte Strompfade zu unterbrechen. Die Ansteuerung der elektrischen Verbraucher erfolgt dabei über Schaltgeräte, die auf der Oberseite der Zentralelektrik, ebenso wie die Sicherungen der Verbraucherstromkreise, steckbar angeordnet sind, wobei Steckerstifte in Steckerbuchsen eingreifen, die an der obersten Flachleiterplatte der Zentralelektrik angebracht sind. Die Kabelbäume sind dabei an der Unterseite der Zentralelektrik über Steckverbinder kontaktiert. Die aufgesteckten Schaltgeräte beinhalten zumeist eine elektronische Steuerschaltung, über die die jeweilige Ansteuerung des zugehörigen elektrischen Verbrauchers erfolgt.

Der eigentliche Schaltvorgang für das Ein- und Ausschalten des Verbrauchers wird über ein im Schaltgerät vorgesehenes Relais vorgenommen. Aufgrund der konstruktiven und fertigungstechnischen Auslegung der Flachleiterplatten und der Steckerbuchsen ist die Zentralelektrik hinsichtlich ihrer Verteilerfunktion starr festgelegt und nur durch einen überdurchschnittlichen Aufwand auf verschiedene unterschiedliche Anforderungen einstellbar bzw. anpaßbar. Anders verlaufende Flachleiterplatten-Stromkreise sind durch besonders kostenintensive Werkzeugänderungen realisierbar, was insbesondere bei kleinen Serien wirtschaftlich nicht vertretbar ist.

Um diesen Nachteil zu beseitigen, ist bereits aus der DE-A 35 25 085 eine Zentralelektrik mit einem Leiterpaket bekannt, das in verschiedenen Ebenen übereinander angeordnete Flachleiterplatten aufweist, die durch Isolierplatten voneinander getrennt sind und denen Steckerbuchsen zur Aufnahme von an bauteilen befindlichen Steckerteilen zugehörig sind, wobei an mindestens einer der Steckerbuchsen mindestens ein das Leiterpaket an mindestens einer Seite überragender Leiterteil angeordnet ist, der mit mindestens einem weiteren an mindestens einer Seite des Leiterpaketes herausragenden und an mindestens einem der isoliert übereinander liegenden Flachleiterplatten angeordneten Leiterteil über eine Leiterbrücke an der Seite des Leiterpaketes wahlweise verbindbar ist. Da die Leiterteile seitlich aus dem Leiterpaket herausragen, ist zum einen vom Platzangebot her die Anzahl der möglichen Stromkreisverbindungen stark begrenzt und zum anderen eine unmittelbare elektrische Verbindung zwischen gegenüberliegenden, aus dem Leiterpaket herausragenden Leiterteilen nicht möglich. Darüber hinaus erfordert die bekannte Zentralelektrik ein aus einer verhältnismäßig großen Anzahl von Flachleiterplatten und Isolierplatten zusammengesetztes Leiterpaket, weil viele freie, nicht belegte Flachleiterplatten-Strompfade notwendig sind, um elektrische Verbindungen von einer Längsseite des Leiterpaketes zur anderen Längsseite des Leiterpaketes zu ermöglichen.

Der Erfindung liegt die Aufgabe zugrunde, eine Zentralelektrik der eingangsgenannten Art zu schaffen, mit der entsprechend den jeweiligen Erfordernissen wahlweise eine große Anzahl verschiedener Flachleiterplatten-Stromkreise mit einfachen Mitteln schaltungsmäßig individuell festgelegt werden können, wobei jedoch möglichst wenig Einzellagen, d.h. Flachleiterplatten und Isolierplatten, notwendig sind.

Diese Aufgabe wird erfindungsgemäß dadurch gelöst, daß zwischen zwei benachbarten Isolierplatten eine elektrische Verteilerplatte mit aufgesetzten Stiftleisten für die Kontaktierung der an den Isolierplatten angrenzenden Flachleiterplatten angeordnet ist, wobei jedem Stift jeder Stiftleiste eine Leiterbahn mit einer freien Anschlußstelle zugeordnet, ist und eine Vielzahl weiterer, separater Leiterbahnen mit mindestens zwei Anschlußstellen auf der Verteilerplatte vorgesehen sind, und daß die Anschlußstellen der Leiterbahnen über in der Höhe gegebenenfalls entsprechend unterschiedlich ausgebildete Drahtbügel wahlweise verbindbar sind

Durch die wahlweise Verbindung der vielen Anschlußstellen der Verteilerplatte über die Drahtbügel sind aufwendige Werkzeugänderungen für anders ausgeführte Flachleiterplatten nicht erforderlich, um eine individuelle Anpassung an die verschiedenen Anforderungen zur Erzielung einer Vielzahl unterschiedlich gestalteter Verbraucherstromkreise zu erreichen, so daß werksseitig die verschiedensten Stromkreise entsprechend den Erfordernissen allein durch einfache Verlagerung der Drahtbügel gestaltet werden können. Darüber hinaus gewährleistet die erfindungsgemäße Zentralelektrik eine kompakte Zusammenfassung aller Strompfade bei einem nur aus wenigen Platten bestehenden Leiterpaket. Zur weiteren Erhöhung der Anzahl der wahlweise herzustellenden Stromkreise sind nach einer vorteilhaften Ausgestaltung der Erfindung die Anschlußstellen der Leiterbahnen der Verteilerplatte über seitlich aus dem Leiterpaket herausragende Drahtbügel mit den Anschlußstellen der isoliert übereinander liegenden Flachleiterplatten wahlweise verbindbar.

Um mit Sicherheit einen Kurzschluß zwischen benachbart angeordneten Drahtbügeln zu vermeiden, sind nach einer vorteilhaften Weiterbildung des Gegenstandes der Erfindung die Drahtbügel mit einem isolierenden Lack überzogen.

Nach einer weiteren Ausgestaltung der erfindungsgemäßen Lösung umfaßt jeder Drahtbügel zwei von einem Basisteil abgewinkelte Steckteile mit einer Anquetschung, wobei der Abstand der Anquetschung von dem freien Ende jedes Steckteils geringfügig größer als die Dicke der Verteilerplatte bzw. der Flachleiterplatten ist. Hierdurch wird eine wesentliche Vereinfachung der Montage der Drahtbügel erreicht, da die Steckteile der Drahtbügel nur bis zu den Anquetschungen in die Anschlußstellen eingesetzt werden können. Zweckmäßigerweise ist gegebenenfalls entsprechend den Erfordernissen das basisteil der Drahtbügel in unterschiedlichen Ebenen gebogen ausgeführt.

Die Leiterbahnen der Verteilerplatte können insofern nachteilig sein, als sich deren Kupferkaschierung beim Verbinden mit den Drahtbügeln, insbesondere beim Laserschweißen, löst, wodurch keine sichere Kontaktierung mehr gewährleistet ist. Weiterhin stellt die relativ geringe Dicke der Kupferkaschierung der Leiterbahnen nicht immer einen ausreichenden Querschnitt für den Stromfluß sicher. Daher sind bei einer vorteilhaften Alternativausführung des Gegenstandes der Erfindung die Stiftleisten durch Stiftreihen und die Leiterbahnen mit ihren freien Anschlußstellen durch in entsprechende Durchbrechungen der Verteilerplatte eingesetzte Kontaktbuchsen ersetzt, deren Durchgangsbohrung jeweils die freien Enden mehrerer zugehöriger Drahtbügel oder den Stift einer Stiftreihe sowie das freie Ende eines bzw. die freien Enden mehrerer zugehöriger Drahtbügel aufnimmt. Durch diese Maßnahme ist eine beschädigung der Kontaktbuchse, die zu einer Schwächung des Querschnittes führen würde, beim Laserschweißen der zu verbindenden Teile ausgeschlossen, was zu einem sicheren Stromübergang zwischen diesen Teilen führt. Weiterhin stellt die Stärke der Kontaktbuchse einen hinreichenden Querschnitt für den Stromfluß sicher. Somit wird ein exakter Stromübergang erreicht.

Um eine sichere Fixierung der Kontaktbuchsen in der Verteilerplatte zu erreichen, besteht bevorzugt jede Kontaktbuchse aus einer Hülse mit einem endseitig umlaufenden Flansch, die mit Preßsitz in die Durchbrechung der Verteilerplatte eingesetzt ist und deren Flansch auf der Oberseite der Verteilerplatte aufliegt.

Bei einer vorteilhaften Weiterbildung des Gegenstandes der Erfindung ist die Hülse der Kontaktbuchse mit Einschnürungen versehen, zwischen denen die freien Enden der Drahtbügel und gegenenfalls der Stift einer Stiftreihe angeordnet ist.

Dadurch ergibt sich auf einfache Weise eine vorgegebene Positionierung der von der Hülse aufzunehmenden Teile.

Zur Erzielung einer kompakten bauweise ist nach einer weiteren vorteilhaften Ausgestaltung der Erfindung die Hülse der Kontaktbuchse mit ihren Einschnürungen derart ausgebildet, daß sich die darin eingesetzten freien Enden der Drahtbügel und gegebenenfalls der Stift einer Stiftreihe seitlich kontaktieren.

Bei einer alternativen Ausführungsform der Erfindung ist jede Kontaktbuchse als Rohrniet ausgebildet, der die darin eingesetzten Enden der Drahtbügel und gegebenenfalls den Stift einer Stiftreihe unter gegenseitiger seitlicher Kontaktierung aufnimmt. Hierdurch kann also ein handelsübliches bauteil verwendet werden.

Um einen festen Halt des Rohrnietes in der Verteilerplatte sicherzustellen, stützt sich zweckmäßigerweise der Kopf des Rohrnietes auf der Oberseite der Verteilerplatte ab und der Fuß des Rohrnietes ist über drei unter 180° zueinander liegenden Auskragungen mit der Unterseite der Verteilerplatte verstemmt.

Weiterhin ist bevorzugt vorgesehen, daß auf der Verteilerplatte bauteile, wie Widerstände, Kondensatoren, Transistoren, Mikroprozessor, der elektronischen Steuerungen für die verschiedenen elektrischen Verbraucher des Kraftfahrzeuges getrennt von den auf einer der oberen Flachleiterplatte des Leiterpaketes zugeordneten Trägerplatte angebrachten Flachstecksicherungen und Schaltgeräten angeordnet und über Leiterbahnen mit den Anschlußstellen der Verteilerplatte verbunden sind. Hierdurch können die elektronischen Steuerungen für die elektrischen Verbraucher mit einfachen Mitteln kostengünstig an der Verteilerplatte hergestellt werden, wodurch auch die auf die Trägerplatte aufsteckbaren Schaltgeräte einfacher und kostengünstiger hergestellt werden können, da weitgehend gleichbleibende Serienausführungen, z.b. nur mit einer Relaisbestückung, verwirklicht werden können.

Um eine kompakte und kostengünstige Zusammenfassung mehrerer verschiedener Elektroniksteuerungen zur Ansteuerung der verschiedenen elektrischen Verbraucher des Kraftfahrzeuges zu erzielen, sind bei einer weiteren vorteilhaften Ausgestaltung der Erfindung die elektronischen Steuerungen für die verschiedenen elektrischen Verbraucher des Kraftfahrzeuges auf der Verteilerplatte in einem Mikrokomputer zentral zusammengefaßt, der mindestens einen als elektronischen Rechner ausgebildeten Mikroprozessor mit mindestens einem Programmspeicher sowie mindestens eine Ein- und Ausgabeeinheit und zugehörige Peripheriegeräte aufweist. Außerdem ist durch die Zusammenfassung im Mikrokomputer der Vorteil gegeben, eine erhebliche Erweiterung der verschiedensten Steuerfunktionen auf kleinstem Raum durchzuführen.

Des weiteren sind zweckmäßigerweise an der unteren Flachleiterplatte des Leiterpaketes Flachstecker, die sich durch den boden eines das Leiterpaket und die Trägerplatte aufnehmenden Gehäuses in einen durch einen am Gehäuseboden angeformten Kragen begrenzten Raum erstrecken, zum Anschluß von Kabelbäumen angeordnet. bevorzugt ist hierbei, daß das Gehäuse mittels eines die Flachstecksicherungen und die Schaltgeräte auf der Trägerplatte übergreifenden Deckels verschlossen ist

Ein Verfahren zur Herstellung und Montage der Drahtbügel für eine Zentralelektrik nach der Erfindung zeichnet sich dadurch aus, daß in Abhängigkeit von der vorgesehenen Plazie - rung der Drahtbügel auf der Verteilerplatte mittels eines rechnergesteuerten Automaten zunächst die Länge und Höhe der Drahtbügel festgelegt, dann die Drahtbügel entsprechend gebogen und anschließend auf der Verteilerplatte montiert und laserverschweißt oder verlötet werden. Durch dieses Verfahren ist eine vollautomatische Produktion der Verteilerplatte gewährleistet.

Der der Erfindung zugrundeliegende Gedanke wird in der nachfolgenden Beschreibung anhand mehrerer Ausführungsbeispiele, die in der Zeichnung dargestellt sind, näher erläutert. Es zeigt:

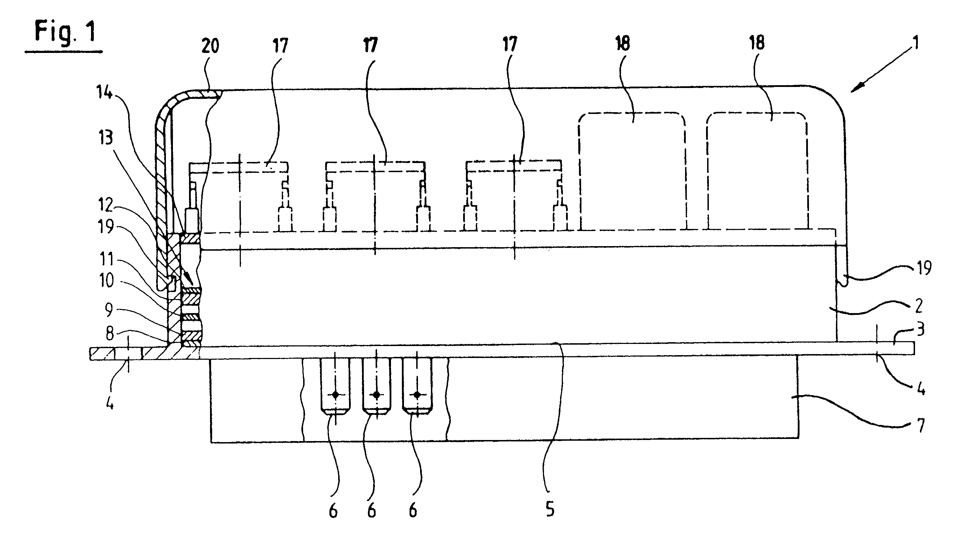

Fig. 1 eine Seitenansicht der Zentralelektrik, teilweise im Schnitt,

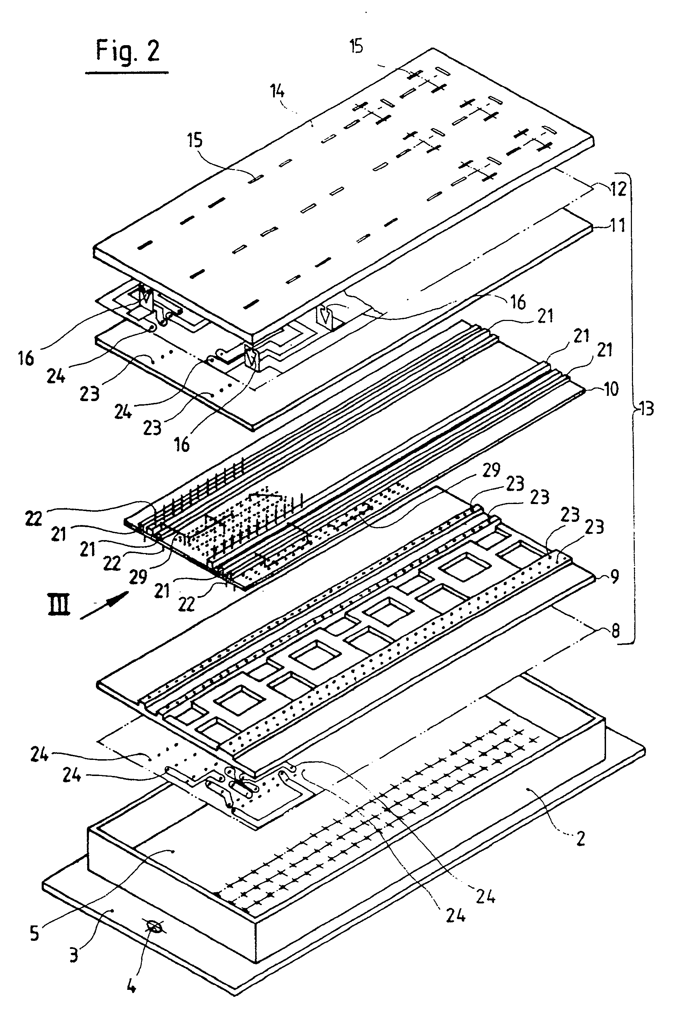

Fig. 2 in perspektivischer Darstellung die Zuordnung der einzelnen Bauteile der Zentralelektrik nach Fig. 1 mit Ausnahme des Gehäusedeckels,

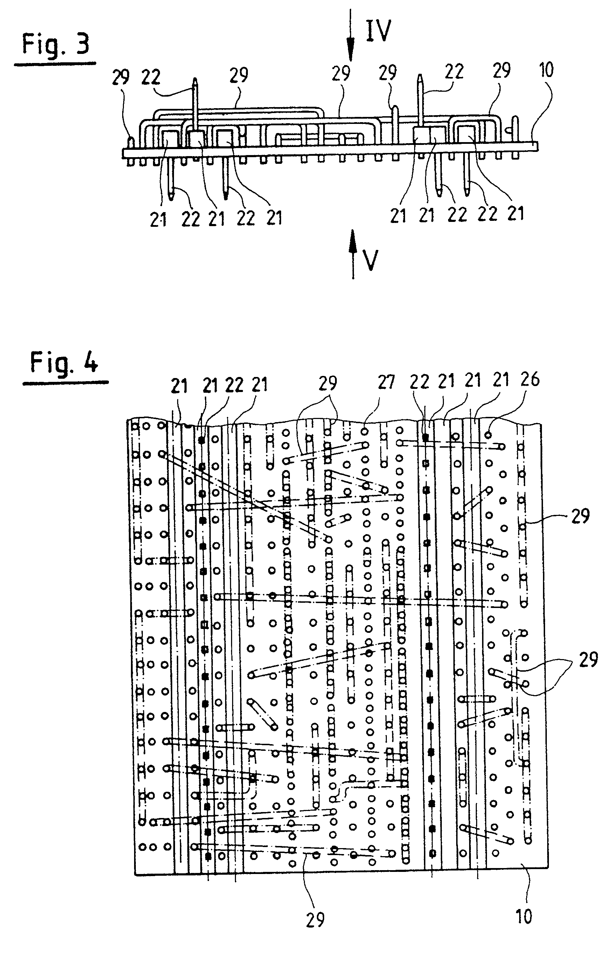

Fig. 3 eine Ansicht der Verteilerplatte der Zentralelektrik nach Fig. 1 in Richtung des Pfeiles III im vergrößerten Maßstab,

Fig. 4 eine Teilansicht der Verteilerplatte nach Fig. 3 in Richtung des Pfeiles IV, in der die Drahtbügel der besseren Übersichtlichkeit wegen strichpunktiert dargestellt sind,

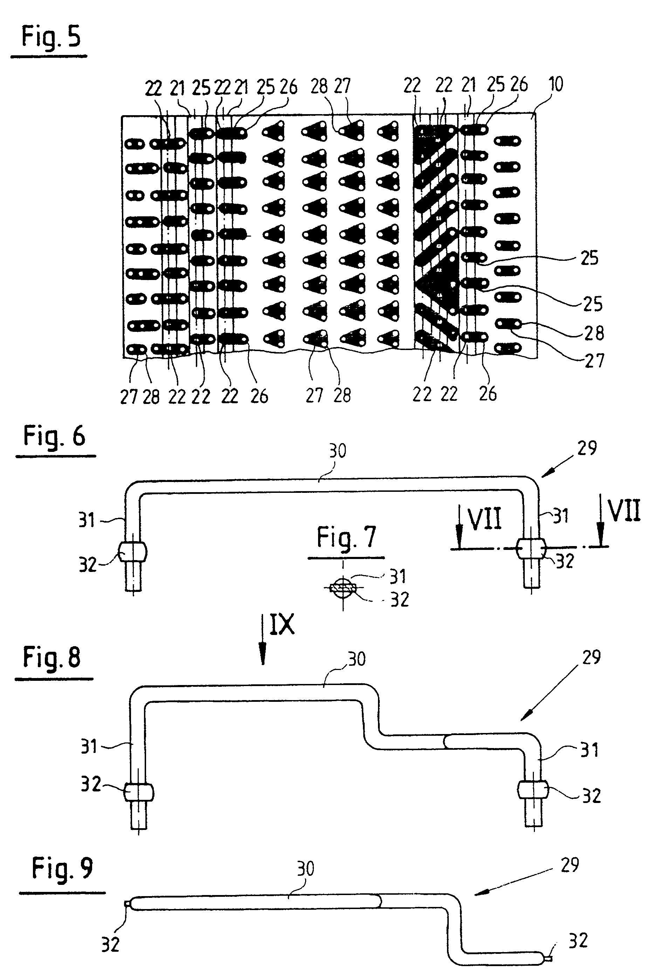

Fig. 5 eine Teilansicht der Verteilerplatte nach Fig. 3 in Richtung des Pfeiles V,

Fig. 6 eine Einzeldarstellung eines Drahtbügels der Verteilerplatte nach Fig. 3 im vergrößerten Maßstab,

Fig. 7 einen Schnitt durch den Drahtbügel nach Fig. 6 gemäß der Linie VII-VII,

Fig. 8 eine alternative Ausführungsform eines Drahtbügels nach Fig. 6,

Fig. 9 eine Ansicht auf den Drahtbügel nach Fig. 8 in Richtung des Pfeiles IX,

Fig. 10 eine alternative Ausführungsform der Zentralelektrik nach Fig. 2,

Fig. 11 eine Ansicht der Verteilerplatte der Zentralelektrik nach Fig. 10 in Richtung des Pfeiles XI im vergrößerten Maßstab,

Fig. 12 eine Teilansicht der Verteilerplatte nach Fig. 11 in Richtung des Pfeiles XII,

Fig. 13 eine Teilansicht der Verteilerplatte nach Fig. 11 in Richtung des Pfeiles XIII,

Fig. 14 eine vergrößerte Darstellung der Einzelheit "XIV" der Fig. 13,

Fig. 15 eine alternative Ausführungsform einer Kontaktbuchse einer Verteilerplatte nach Fig. 12 im vergrößerten Maßstab,

Fig. 16 einen Schnitt durch die Darstellung nach Fig. 15 gemäß der Linie XVI-XVI,

Fig. 17 eine weitere Alternativausführung einer Kontaktbuchse,

Fig. 18 eine andere Alternativausführung einer Kontaktbuchse,

Fig. 19 eine weitere Alternativausführung der Kontaktbuchse als Rohrniet und

Fig. 20 einen Schnitt durch die Darstellung nach Fig. 19 gemäß der Linie XX-XX.

Die für den Einbau in ein Kraftfahrzeug vorgesehene Zentralelektrik 1 ist so ausgeführt, daß hier eine große Anzahl von elektrischen Steuerleitungen und Stromkreisen für Verbraucher, wie Lampen, Scheibenwischer, Blinker, Heckscheibenheizung, Sitzheizung, Spiegelheizung, Magnetventile und dergleichen mittels Steckverbindungen zentral zusammengefaßt werden können. Die Zentralelektrik 1 weist ein aus Kunststoff bestehendes Gehäuse 2 auf, das über seitlich vorstehende Flansche 3 mit Durchgangsbohrungen 4 an einem nicht näher dargestellten Halteteil befestigbar ist. An der Unterseite des Bodens 5 des Gehäuses 2 ragen Flachstecker 6 heraus, an denen die mit Steckverbindern versehenen Kabelbäume angeschlossen werden können. Ein an dem Boden 5 angeformter Kragen 7 umgibt die Flachstecker 6, die durch den Boden 5 hindurch an eine auf der Innenseite des Bodens 5 aufliegende, als Stanzgitter ausgebildete Flachleiterplatte 8 angeschlossen sind. Auf der Flachleiterplatte 8 sind übereinander eine untere Isolierplatte 9, eine elektrische Verteilerplatte 10, eine obere Isolierplatte 11 und eine obere als Stanzgitter ausgebildete Flachleiterplatte 12 angeordnet, die insgesamt ein plattenartig geschichtetes Leiterpaket 13 bilden. Oberhalb des Leiterpaketes 13 ist in das Gehäuse 2 eine Trägerplatte 14 mit Schlitzausnehmungen 15 eingesetzt, unter denen sich auf der oberen Flachleiterplatte 12 angebrachte Steckerbuchsen 16 befinden. Auf der Oberseite der Trägerplatte 14 sind aufgesteckte bauteile, wie elektrische Flachstecksicherungen 17 und ein Relais enthaltende Schaltgeräte 18 angeordnet, die mit ihren Steckerteilen durch die Schlitzausnehmungen 15 hindurch in die Steckerbuchsen 16 eingreifen. Über die Flachstecksicherungen 17 und die Schaltgeräte 18 erstreckt sich ein über Schnappverbindungen 19 am Gehäuse 2 befestigter Deckel 20. Auf der Oberseite der zwischen der unteren und der oberen Isolierplatte 9 bzw. 11 angebrachten Verteilerplatte 10 befinden sich jeweils längsrandseitig drei parallel zueinander verlaufende, durchgehende Stiftleisten 21, deren in Reihe angeordnete Stifte 22 durch entsprechende Ausnehmungen 23 in den Isolierplatten 9 und 11 entweder die zugehörigen Anschlußstellen 24 der unteren Flachleiterplatte 8 oder der oberen Flachleiterplatte 12 kontaktieren. Auf der Unterseite der Verteilerplatte 10 ist jeder Stift 22 jeder Stiftleiste 21 mit einer Leiterbahn 25 mit mindestens einer Anschlußstelle 26 verlötet. Des weiteren befinden sich auf der Unterseite der Verteilerplatte 10 eine Vielzahl separater Leiterbahnen 27 mit mindestens zwei Anschlußstellen 28. Entsprechend den geforderten Stromkreisen sind bestimmte Anschlußstellen 26, 28 der Verteilerplatte 10 untereinander über mit einem isolierenden Lack überzogene Drahtbügel 29 verbunden. Um ein Überkreuzen der Drahtbügel 29 ohne gegenseitige berührung sicherzustellen, weisen die Drahtbügel 29 dementsprechend unterschiedliche Höhen auf. Sollen nun andere Stromkreise geschaltet werden, dann sind lediglich die Drahtbügel 29 entsprechend anders auf der Verteilerplatte 10 anzuordnen. Durch die wahlweise Anbringung der Drahtbügel 29 kann somit eine große Anzahl verschiedenster Stromkreise realisiert werden.

Jeder Drahtbügel 29 umfaßt ein basisteil 30, von dem jeweils endseitig ein Steckteil 31 abgewinkelt ist. Das basisteil 30 des Drahtbügels 29 kann zur Herstellung bestimmter Verbindungswege in unterschiedlichen Ebenen gebogen ausgeführt sein. Jedes Steckteil 31 eines Drahtbügels 29 weist eine Anquetschung 32 auf, deren Unterseite von dem freien Ende des Steckerteils 31 einen Abstand hat, der geringfügig größer als die Dicke der Verteilerplatte 10 ist. Damit ist auf einfache Weise die Einstecktiefe der Drahtbügel 29 in die Anschlußstellen 26, 28 der Verteilerplatte 10 festgelegt, was die Verlötung mit den Leiterbahnen 25, 27 der Verteilerplatte 10 wesentlich erleichtert.

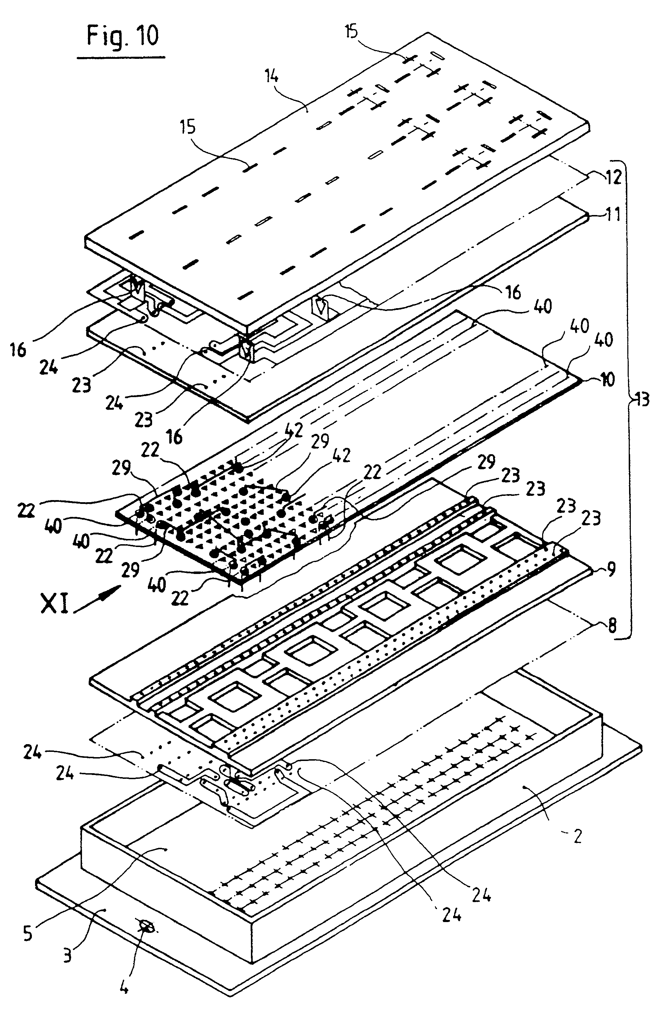

Bei der in Fig. 10 dargestellten Alternativausführung der Zentralelektrik befinden sich auf der Oberseite der Verteilerplatte 10 jeweils längsrandseitig drei parallel zueinander verlaufende, durchgehende Stiftreihen 40, deren Stifte 22 durch die entsprechenden Ausnehmungen 23 in den Isolierplatten 9 und 11 entweder die zugehörigen Anschlußstellen 24 der unteren Flachleiterplatte 8 oder der oberen Flachleiterplatte 12 kontaktieren. Jeder Stift 22 jeder Stiftreihe 40 ist in eine in einer entsprechenden Durchbrechung 41 der Verteilerplatte 10 angeordneten Kontaktbuchse 42 eingesetzt und mit dieser laserverschweißt, wobei die Durchgangsbohrung 43 der Kontaktbuchse 42 mindestens noch einen freien bereich für die Aufnahme des freien Endes eines Drahtbügels 29 aufweist. Weiterhin sind in die Verteilerplatte 10 eine Vielzahl freier Durchbrechungen 41 eingelassen, in die bedarfsweise Kontaktbuchsen 42, deren Durchgangsbohrung 43 mindestens zwei freie Enden zweier Drahtbügel 29 aufnehmen kann, eingesetzt werden können. Entsprechend den geforderten Stromkreisen sind die Kontaktbuchsen 42 der Verteilerplatte 10 untereinander über die Drahtbügel 29 verbunden, wobei je nach Anwendungsfall die Drahtbügel 29 miteinander oder mit der Kontaktbuchse 42 oder ein Drahtbügel 29 mit einem Stift 22 einer Stiftreihe 40 laserverschweißt ist.

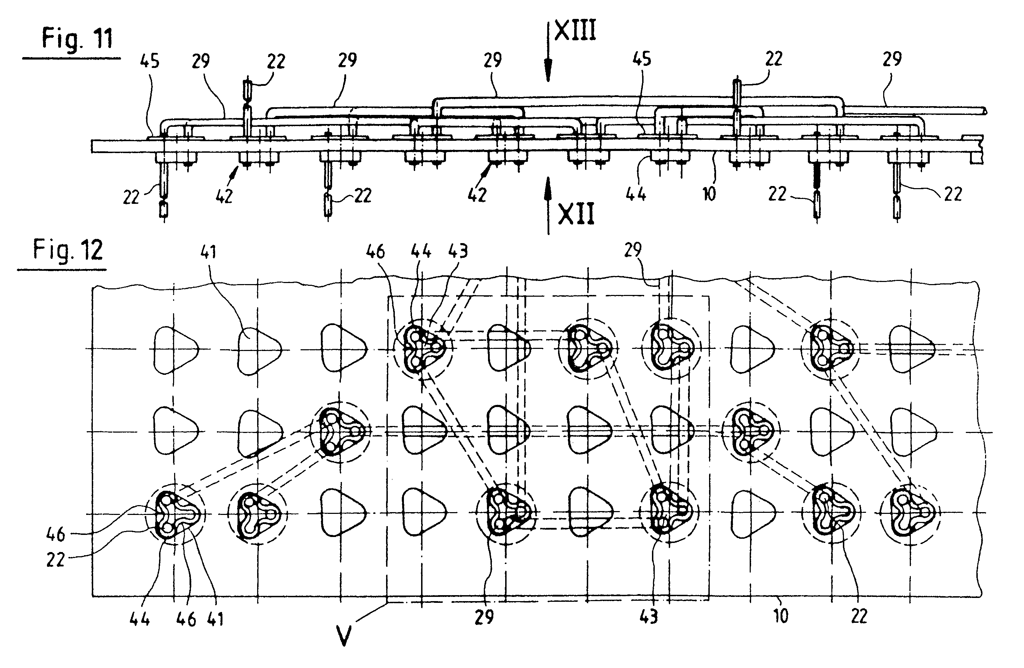

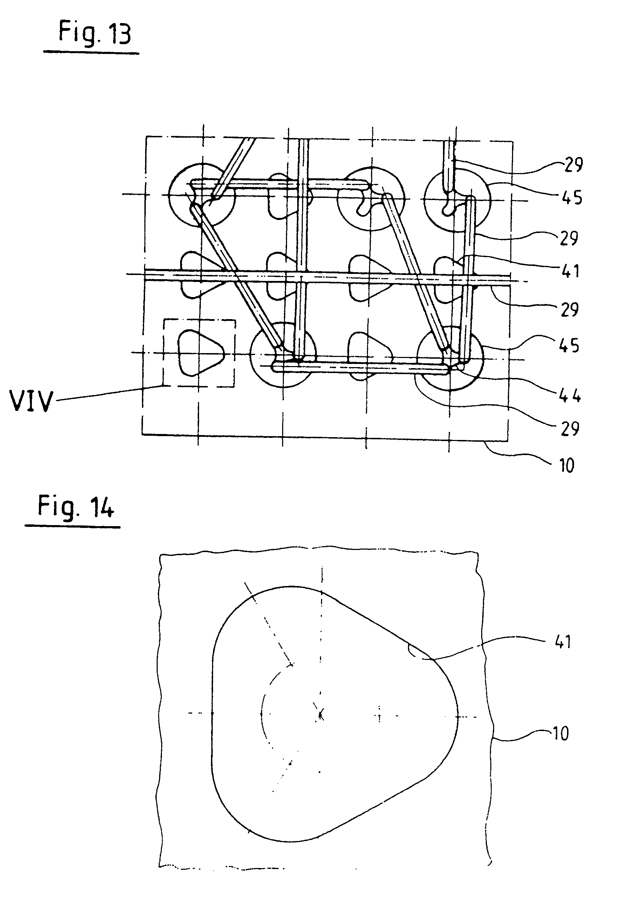

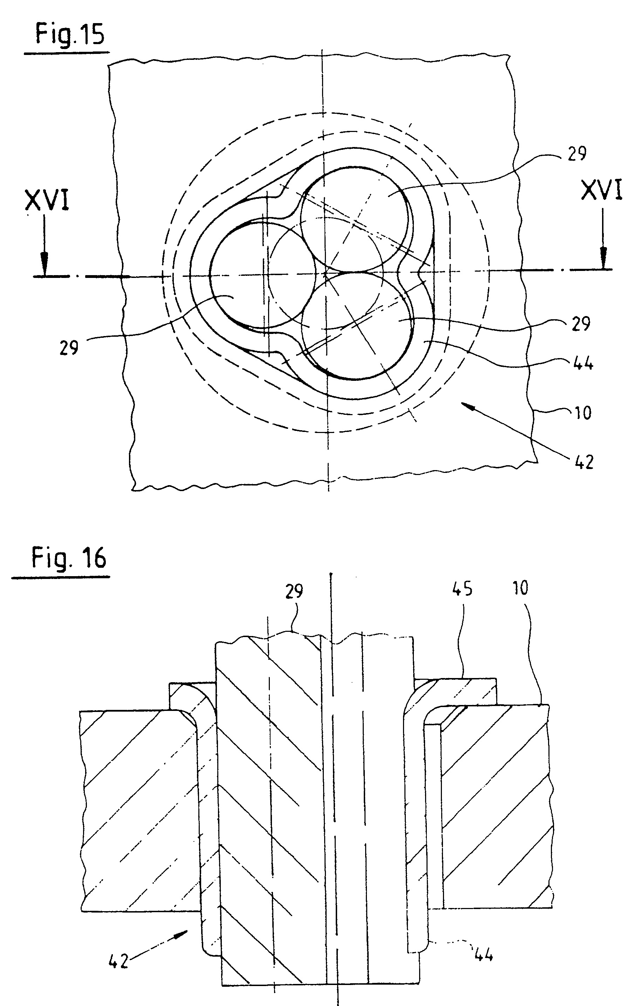

Die in den Fig. 11 bis 18 veranschaulichten Kontaktbuchsen 42 der Verteilerplatte 10 bestehen jeweils aus einer Hülse 44, an derem einen Ende außenseitig ein umlaufender Flansch 45 angeformt ist. Die Hülse 44 ist mit Preßsitz in die zugehörige Durchbrechung 41 der Verteilerplatte 10 eingesetzt, wobei der Flansch 45 auf der Oberseite der Verteilerplatte 10 aufliegt. Das dem Flansch 45 abgewandte Ende der Hülse steht geringfügig über die Unterseite der Verteilerplatte 10 vor. Die von der Hülse 44 aufgenommenen Drahtbügel 29 bzw. der Stift 22 einer Stiftreihe 40 erstrecken sich geringfügig über das dem Flansch 45 abgewandte Ende der Hülse 44. Dies ermöglicht eine günstige Laserschweißung zwischen den zu verbindenden Teilen. Die Hülse 44 der Kontaktbuchse 42 weist durchgehende Einschnürungen 46 auf, zwischen denen die freien Enden der im Querschnitt rund ausgebildeten Drahtbügel 29 und gegebenenfalls der Stift 22 einer Stiftreihe 40 angeordnet ist. Bei den Kontaktbuchsen 42 nach den Fig. 11 bis 14 besitzt die Hülse 44 drei um 120° zueinander versetzte Einschnürungen 46, wobei die Abmessung der Hülse 44 derart ausgebildet ist, daß trotz eingesetzter Drahtbügel 29 bzw. des Stiftes 22 einer Stiftreihe 40 in die Durchgangsbohrung 43 zwischen den Einschnürungen 46 der Hülse 44 der mittlere bereich der Durchgangsbohrung 43 freibleibt, d.h. die in die Hülse 44 eingesetzten Teile kontaktieren sich nicht. Eine Laserschweißung ist demnach zwischen jedem eingesetzten Teil und der Kontaktbuchse 42 erforderlich. Demgegenüber ist die in den Fig. 15 und 16 gezeigte Kontaktbuchse 42, die in ihrer Konfiguration den Kontaktbuchsen 42 nach den Fig. 11 bis 14 entspricht, so bemessen, daß sich die darin eingesetzten Drahtbügel 29 seitlich kontaktieren. Dadurch sind nur zwei Laserschweißstellen zwischen den sich berührenden Drahtbügeln 29 erforderlich.

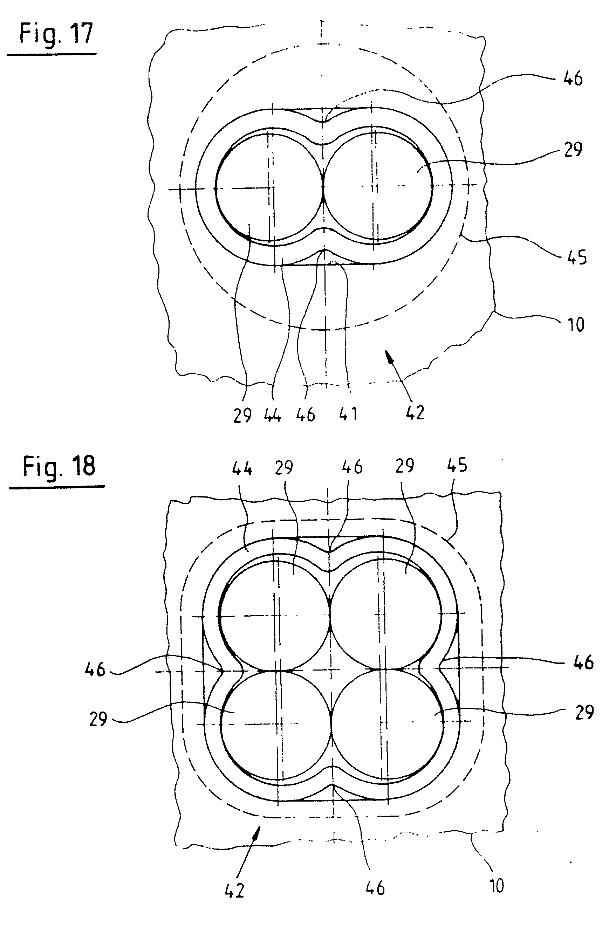

Die in Fig. 17 dargestellte, alternative Kontaktbuchse 42 nimmt nur zwei Drahtbügel 29 auf, die sich im Bereich der gegenüberliegenden Einschnürungen 46 der Hülse 44 seitlich kontaktieren und hier laserverschweißt sind. Die in Fig. 18 veranschaulichte Alternative der Kontaktbuchse 42 ist für die Aufnahme von vier Drahtbügeln 29 geeignet. Die Hülse 44 dieser Kontaktbuchse 42 besitzt vier unter 90° zueinander versetzt angeordnete Einschnürungen 46 ,zwischen denen die Drahtbügel 29 unter seitlicher Kontaktierung liegen. In diesem Falle sind drei Laserschweißstellen zwischen den Drahtbügeln 29 erforderlich.

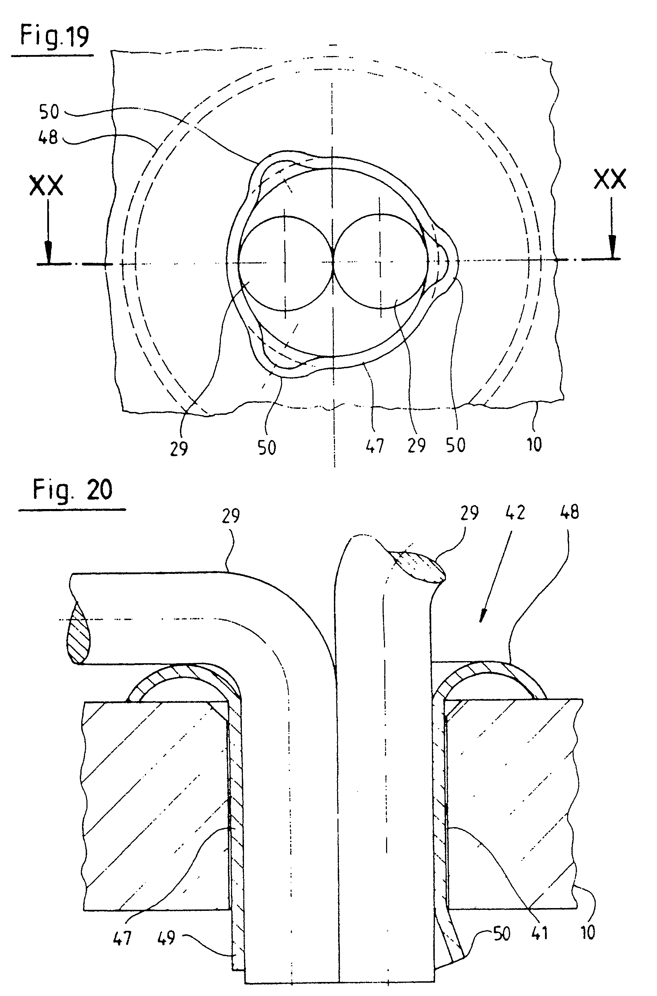

bei der in den Fig. 19 und 20 dargestellten alternativen Kontaktbuchse 42 ist dieselbe als Rohrniet 47 ausgebildet. In Abhängigkeit von dem Innendurchmesser des Rohrnietes 47 können darin zwei oder mehrere Drahtbügel 29 unter seitlicher Kontaktierung eingesetzt werden. Die Drahtbügel 29 sind hierbei an den entsprechenden Berührungsstellen laserverschweißt. Der in eine zugehörige Durchbrechung 41 der Verteilerplatte 10 eingesetzte Rohrniet 47 stützt sich mit seinem Kopf 48 auf der Oberseite der Verteilerplatte 10 ab, wobei der Fuß 49 des Rohrnietes 47 über drei unter 120° zueinander liegende Auskragungen 50 mit der Unterseite der Verteilerplatte 10 vestemmt ist. So ergibt sich ein sicherer Halt des Rohrnietes 47 in der Verteilerplatte 10.

Im übrigen wird die Verteilerplatte 10 nach bestückung und Laserverschweißung zusätzlich gelötet, um eine weitere Absicherung der Stromkreise zu erhalten.

Die vorstehende Zeichnungsbeschreibung hat die besonders einfache und praktisch zu handhabende Konstruktion der Zentralelektrik, die sich unbeschadet ihrer Einfachheit gleichwohl als äußerst variabel erweist, in ihren Einzelheiten verdeutlicht.

**Patentansprüche**

1. Zentralelektrik für Kraftfahrzeuge zum zentralen Anschluß elektrischer Bauteile, wie Sicherungen (17), Schaltgeräte (18), Kabelbäume, elektronische Steuerungen für elektrische Verbraucher und dergleichen, mit einem plattenartig geschichteten Leiterpaket (13), das in verschiedenen Ebenen übereinander angeordnete, durch Isolierplatten (9, 11) voneinander getrennte Flachleiterplatten (8, 12) aufweist, dadurch gekennzeichnet, daß zwischen zwei benachbarten Isolierplatten (9, 11) eine elektrische Verteilerplatte (10) mit aufgesetzten Stiftleisten (21) für die Kontaktierung der an den Isolierplatten (9, 11) angrenzenden Flachleiterplatten (8, 12) angeordnet ist, wobei jedem Stift (22) jeder Stiftleiste (21) eine Leiterbahn (25) mit einer freien Anschlußstelle (26) zugeordnet ist, und eine Vielzahl weiterer, separater Leiterbahnen (27) mit mindestens zwei Anschlußstellen (28) auf der Verteilerplatte (10) vorgesehen sind, und daß die Anschlußstellen (26, 28) der Leiterbahnen (25, 27) über in der Höhe gegebenenfalls entsprechend unterschiedlich ausgebildete Drahtbügel (29) wahlweise verbindbar sind.

2. Zentralelektrik nach Anspruch 1, dadurch gekennzeichnet, daß die Anschlußstellen (26, 28) der Leiterbahnen (25, 27) der Verteilerplatte (10) über seitlich aus dem Leiterpaket (13) herausragende Drahtbügel (29) mit den Anschlußstellen (24) der isoliert übereinander liegenden Flachleiterplatten (8, 12) wahlweise verbindbar sind.

3. Zentralelektrik nach Anspruch 1 oder 2, dadurch gekennzeichnet, daß die Drahtbügel (29) mit einem isolierenden Lack überzogen sind.

4. Zentralelektrik nach einem oder mehreren der Ansprüche 1 bis 3, dadurch gekennzeichnet, daß jeder Drahtbügel (29) zwei von einem Basisteil (30) abgewinkelte Steckteile (31) mit einer Anquetschung (32) umfaßt, wobei der Abstand der Anquetschung (32) von dem freien Ende jedes Steckteils (31) geringfügig größer als die Dicke der Verteilerplatte (10) bzw. der Flachleiterplatten (8, 12) ist.

5. Zentralelektrik nach einem oder mehreren der Ansprüche 1 bis 4, dadurch gekennzeichnet, daß das Basisteil (30) der Drahtbügel (29) in unterschiedlichen Ebenen gebogen ausgeführt ist.

6. Zentralelektrik nach einem oder mehreren der Ansprüche 1 bis 5, dadurch gekennzeichnet, daß die Stiftleisten (21) durch Stiftreihen (40) und die Leiterbahnen (25, 27) mit ihren freien Anschlußstellen (26, 28) durch in entsprechende Durchbrechungen (41) der Verteilerplatte (10) eingesetzte Kontaktbuchsen (42) ersetzt sind, deren Durchgangsbohrung (43) jeweils die freien Enden mehrerer zugehöriger Drahtbügel (29) oder den Stift (22) einer Stiftreihe (40) sowie das freie Ende eines bzw. die freien Enden mehrerer zugehöriger Drahtbügel (29) aufnimmt.

7. Zentralelektrik nach einem oder mehreren der Ansprüche 1 bis 6, dadurch gekennzeichnet, daß jede Kontaktbuchse (42) aus einer Hülse (44) mit einem endseitig umlaufenden Flanch (45) besteht, die mit Preßsitz in die Durchbrechung (41) der Verteilerplatte (10) eingesetzt ist, und deren Flansch (45) auf der Oberseite der Verteilerplatte (10) aufliegt.

8. Zentralelektrik nach einem oder mehreren der Ansprüche 1 bis 7, dadurch gekennzeichnet, daß die Hülse (44) der Kontaktbuchse (42) mit Einschnürungen (46) versehen ist, zwischen denen die freien Enden der Drahtbügel (29) und gegebenenfalls der Stift (22) einer Stiftreihe (40) angeordnet ist.

9. Zentralelektrik nach einem oder mehreren der Ansprüche 1 bis 8, dadurch gekennzeichnet, daß die Hülse (44) der Kontaktbuchse (42) mit ihren Einschnürungen (46) derart ausgebildet ist, daß sich die darin eingesetzten freien Enden der Drahtbügel (29) und gegebenenfalls der Stift (22) einer Stiftreihe (40) seitlich kontaktieren.

10. Zentralelektrik nach einem oder mehreren der Ansprüche 1 bis 9, dadurch gekennzeichnet, daß jede Kontaktbuchse (42) als Rohrniet (47) ausgebildet ist, der die darin eingesetzten Enden der Drahtbügel (29) und gegebenenfalls den Stift (22) einer Stiftreihe (40) unter gegenseitiger seitlicher Kontaktierung aufnimmt.

11. Zentralelektrik nach einem oder mehreren der Ansprüche 1 bis 10, dadurch gekennzeichnet, daß der Kopf (48) des Rohrnietes (47) sich auf der Oberseite der Verteilerplatte (10) abstützt, und der Fuß (49) des Rohrnietes (47) über drei unter 120° zueinander liegende Auskragungen (50) mit der Unterseite der Verteilerplatte (10) verstemmt ist.

12. Zentralelektrik nach einem oder mehreren der Ansprüche 1 bis 11, dadurch gekennzeichnet, daß auf der Verteilerplatte (10) Bauteile, wie Widerstände, Kondensatoren, Transistoren, Mikroprozessor, der elektronischen Steuerungen für die verschiedenen elektrischen Verbraucher des Kraftfahrzeuges getrennt von dem auf einer der oberen Flachleiterplatte (12) des Leiterpaketes (13) zugeordneten Trägerplatte (14) angebrachten Flachstecksicherungen (17) und Schaltgeräten (18) angeordnet und über Leiterbahnen mit Anschlußstellen der Verteilerplatte (10) verbunden sind.

13. Zentralelektrik nach einem der Ansprüche 1 bis 12, dadurch gekennzeichnet, daß die elektronischen Steuerungen für die verschiedenen elektrischen Verbraucher des Kraftfahrzeuges auf der Verteilerplatte (10) in einem Mikrokomputer zentral zusammengefaßt sind, der mindestens einen als elektronischen Rechner ausgebildeten Mikroprozessor mit mindestens einem Programmspeicher sowie mindestens eine Ein- und Ausgabeeinheit und zugehörige Peripheriegeräte aufweist.

14. Zentralelektrik nach einem der Ansprüche 1 bis 13, dadurch gekennzeichnet, daß an der unteren Flachleiterplatte (8) des Leiterpaketes (13) Flachstecker (6), die sich durch den Boden (5) eines das Leiterpaket (13) und die Trägerplatte (14) aufnehmenden Gehäuses (2) in einen durch einen am Gehäuseboden (5) angeformten Kragen (7) begrenzten Raum erstrecken, zum Anschluß von Kabelbäumen angeordnet sind.

15. Zentralelektrik nach einem oder mehreren der Ansprüche 1 bis 14, dadurch gekennzeichnet, daß das Gehäuse (2) mittels eines die flachstecksicherungen (17) und die Schaltgeräte (18) auf der Trägerplatte (14) übergreifenden Deckels (20) verschlossen ist

16. Verfahren zur Herstellung und Montage der Drahtbügel für eine Zentralelektrik nach einem oder mehreren der Ansprüche 1 bis 15, dadurch gekennzeichnet, daß in Abhängigkeit von der vorgesehenen Pla-zierung der Drahtbügel (29) auf der Verteilerplatte (10) mittels eines rechnergesteuerten Automaten zunächst die Länge und Höhe der Drahtbügel festgelegt, dann die Drahtbügel entsprechend gebogen und anschließend auf der Verteilerplatte (10) montiert und laserverschweißt und/oder verlötet werden.

**Claims**

1. A central circuit arrangement for motor vehicles for the central connection of electrical components, such as fuses (17), switching devices (18), wiring harnesses, electronic controls for electrical loads and the like and including a plate-like layered conductor packet (13) which is composed of flat printed circuit boards (8, 12) that are arranged on top of one another in different planes and are separated from one another by insulating plates (9, 11), characterized in that an electrical distributor plate (10) with attached pin strips (21) for contacting the flat printed circuit boards (8, 12) adjacent to the insulating plate (9, 11) is disposed between two adjacent insulating plates (9, 11), with each pin (22) of each pin strip (21) having an associated conductor path (25) and a free terminal (26); a plurality of further, separate conductor paths (27) having at least two terminals (28) are provided on the distributor plate (10); and the terminals (26, 28) of the conductor paths (25, 27) can be selectively connected by way of straps (29) which, if required, are configured to have different heights.

2. A central circuit arrangement according to claim 1, characterized in that the terminals (26, 28) of the conductor paths (25, 27) of the distributor plate (10) are selectively connectable with the terminals (24) of the insulated, superposed, flat printed circuit boards (8, 12) by way of straps (29) that laterally project from the conductor packet (13).

3. A central circuit arrangement according to claim 1 or 2, characterized in that the straps (29) are coated with an insulating lacquer.

4. A central circuit arrangement according to one or a plurality of claims 1 to 3, characterized in that each strap (29) includes two plug-in portions (31) which are angled off from a base portion (30) and are provided with a pinched region (32), with the distance of the pinched region (32) from the free end of each plug-in portion (31) being slightly larger than the thickness of the distributor plate (10) or the flat printed circuit boards (8, 12).

5. A central circuit arrangement according to one or a plurality of claims 1 to 4, characterized in that the base portion (30) of the straps (29) is bent into different planes.

6. A central circuit arrangement according to one or a plurality of claims 1 to 5, characterized in that the pin strips (21) are replaced by rows of pins (40) and the conductor paths (25, 27) and their free terminals (26, 28) are replaced by contact sockets (42) that are inserted into corresponding perforations (41) in the distributor plate (10), with the passage bore (43) of each contact socket receiving the free ends of a plurality of associated straps (29) or the pin (22) of a row of pins (40) as well as the free end of an associated strap (29) or the free ends of a plurality of associated straps, respectively.

7. A central circuit arrangement according to one or a plurality of claims 1 to 6, characterized in that each contact socket (42) is composed of a sleeve (44) provided with a continuous flange (45) at its end, with the sleeve being inserted in a press fit into the perforation (41) of the distributor plate (10) and its flange (45) resting on the upper face of the distributor plate (10).

8. A central circuit arrangement according to one or a plurality of claims 1 to 7, characterized in that the sleeve (44) of the contact socket (42) is provided with constrictions (46) between which are disposed the free ends of the straps (29) and, if required, the pin (22) of a row of pins (40).

9. A central circuit arrangement according to one or a plurality of claims 1 to 8, characterized in that the sleeve (44) of the contact socket (42) and its constrictions (46) are configured in such a manner that the free ends of the straps (29) inserted thereinto and, if required, the pin (22) of a row of pins (40) laterally contact one another.

10. A central circuit arrangement according to one or a plurality of claims 1 to 9, characterized in that each contact socket (42) is configured as a tubular rivet (47) which accommodates the inserted ends of the straps (29) and, if required, the pin (22) of a row of pins (40) in mutual lateral contact.

11. A central circuit arrangement according to one or a plurality of claims 1 to 10, characterized in that the head (48) of the tubular rivet (47) is supported on the upper face of the distributor plate (10) and the base (49) of the tubular rivet (47) is caulked together with the underside of the distributor plate (10) by way of three projections (50) spaced at 120° from one another.

12. A central circuit arrangement according to one or a plurality of claims 1 to 11, characterized in that components, such as resistors, capacitors, transistors, microprocessors, of the electronic controls for the various electrical loads of the motor vehicle are disposed on the distributor plate (10) separated from the flat plug-in fuses (17) and switching devices (18) disposed on a carrier plate (14) associated with the upper flat printed circuit board (12) of the conductor packet (13) and are connected with terminals of the distributor plate (10) by way of conductor paths.

13. A central circuit arrangement according to one of claims 1 to 12, characterized in that the electronic controls for the various electrical loads of the motor vehicle are centrally combined on the distributor plate (10) in a microcomputer which includes at least one microprocessor in the form of an electronic computer and at least one program memory as well as at least one input/output unit and associated peripherals.

14. A central circuit arrangement according to one of claims 1 to 13, characterized in that plain connectors (6) extending through the bottom (5) of a housing (2) accommodating the conductor packet (13) and the carrier plate (14) and being delimited by a collar (7) formed at the housing bottom (5) are disposed at the lower flat printed circuit board (8) of the conductor packet (13) for the connection of wiring harnesses.

15. A central circuit arrangement according to one or a plurality of claims 1 to 14, characterized in that the housing (2) is closed by means of a lid (20) which extends over the flat plug-in fuses (17) and the switching devices (18) on the carrier plate (14).

16. A method of producing and installing the straps for a central circuit arrangement according to one or a plurality of claims 1 to 15, characterized in that, in dependence on the intended placement of the straps (29) on the distributor plate (10), the length and height of the straps are initially determined by means of a computer controlled automatic apparatus, then the straps are bent accordingly and thereafter they are installed on the distributor plate (10) and laser welded and/or soldered.

## Revendications

1. Boîtier électrique central pour véhicules automobiles pour le raccordement central des composants électriques tels que fusibles (17), commutateurs (18), faisceaux de câbles, commandes électroniques pour les utilisateurs électriques et analogues, avec un paquet de conducteurs stratifié en forme de plaque (13) qui présente des plaquettes de conducteurs plats (8, 12) disposées les unes au-dessus des autres à différents niveaux, séparées les unes des autres par des plaques isolantes (9, 11), caractérisé en ce qu'une plaque de distributeur électrique (10) avec des baguettes à ergots (21) est disposée entre deux plaques isolantes voisines (9, 11) pour l'établissement du contact des plaquettes de conducteurs plats (8, 12) aboutissant aux plaques isolantes (9, 11), une piste conductive (25) avec un point de raccordement libre (26) étant associée à chaque ergot (22) de chaque baguette à ergots (21) et une pluralité d'autres pistes conductives séparées (27) avec au moins deux points de raccordement (28) étant prévue sur la plaque de distributeur (10), et en ce que les points de raccordement (26, 28) des pistes conductives (25, 27) peuvent être reliées facultativement par l'imtermédiaire de barrettes de fil (29) conçues le cas échéant de hauteur différente.

2. Boîtier électrique central selon la revendication 1, caractérisé en ce que les points de raccordement (26, 28) des pistes conductives (25, 27) de la plaque de distributeur (10) peuvent être reliés facultativement aux points de raccordement (24) des plaquettes de conducteurs plats (8, 12) superposées isolées par l'intermédiaire de barrettes de fil (29) dépassant latéralement du paquet de conducteurs (13).

3. Boîtier électrique central selon la revendication 1 ou 2, caractérisé en ce que les barrettes de fil (29) sont revêtues d'un vernis isolant.

4. Boîtier électrique central selon une ou plusieurs des revendications 1 à 3, caractérisé en ce que chaque barrette de fil (29) comprend deux pièces d'emboîtement (31) avec un pincement (32) pliées en U à partir d'une pièce de base (30), l'écartement du pincement (32) par rapport à l'extrémité libre de chaque pièce d'emboîtement (31) étant légèrement supérieur à l'épaisseur de la plaque de distributeur (10) ou des plaquettes de conducteurs plats (8, 12).

5. Boîtier électrique central selon une ou plusieurs des revendications 1 à 4, caractérisé en ce que la pièce de base (30) des barrettes de fil (29) est réalisée cintrée à différents niveaux.

6. Boîtier électrique central selon une ou plusieurs des revendications 1 à 5, caractérisé en ce que les baguettes à ergots (21) sont remplacées par des rangées d'ergots (40) et les pistes conductives (25, 27) avec leurs points de raccordement libres (26, 28) par des douilles de contact (42) insérées dans des découpes correspondantes (41) de la plaque de distributeur (10), dont le perçage débouchant (43) loge chaque fois les extrémités libres de plusieurs barrettes de fil qui leur sont associées (29), ou l'ergot (22) d'une rangée d'ergots (40) ainsi que l'extrémité libre d'une ou les extrémités libres de plusieurs barrettes de fil qui leur sont associées (29).

7. Boîtier électrique central selon une ou plusieurs des revendications 1 à 6, caractérisé en ce que chaque douille de contact (42) est constituée d'une gaine (44) avec une bride (45) tournante à l'extrémité, qui est insérée avec ajustement serré dans la découpe (41) de la plaque de distributeur (10) et dont la bride (45) repose sur le côté supérieur de la plaque de distributeur (10).

8. Boîtier électrique central selon une ou plusieurs des revendications 1 à 7, caractérisé en ce que la gaine (44) de la douille de contact (42) est munie de rétrécissements (46) entre lesquels sont disposées les extrémités libres des barrettes de fil (29) et le cas échéant l'ergot (22) d'une rangée d'ergots (40).

9. Boîtier électrique central selon une ou plusieurs des revendications 1 à 8, caractérisé en ce que la gaine (44) de la douille de contact (42) avec ses rétrécissements (46) est conçue de telle façon que les extrémités libres des barrettes de fil (29) insérées à l'intérieur de celle-ci et le cas échéant l'ergot (22) d'une rangée d'ergots (40) sont mis en contact latéralement.

10. Boîtier électrique central selon une ou plusieurs des revendications 1 à 9, caractérisé en ce que chaque douille de contact (42) est conçue comme un rivet tubulaire (47) qui loge les extrémités des barrettes de fil (29) insérées à l'intérieur de celle-ci et le cas échéant l'ergot (22) d'une rangée d'ergots (40) moyennant un contact latéral réciproque.

11. Boîtier électrique central selon une ou plusieurs des revendications 1 à 10, caractérisé en ce que la tête (48) du rivet tubulaire (47) s'appuie sur le côté supérieur de la plaque de distributeur (10) et en ce que le pied (49) du rivet tubulaire (47) est rabattu avec le côté inférieur de la plaque de distributeur (10) au-dessus de trois saillies (50) situées à 120 ° les unes des autres.

12. Boîtier électrique central selon une ou plusieurs des revendications 1 à 11, caractérisé en ce que des composants tels que résistances, condensateurs, transistors, microprocesseur des commandes électroniques pour les différents utilisateurs électriques du véhicule automobile sont disposés sur la plaque de distributeur (10) séparément des fusibles à fiche plate (17) et des commutateurs (18) placés sur une plaque support (14) associée à la plaquette supérieure de conducteurs plats (12) du paquet de conducteurs (13) et reliés aux points de raccordement de la plaque de distributeur (10) par l'intermédiaire de pistes conductives.

13. Boîtier électrique central selon une ou plusieurs des revendications 1 à 12, caractérisé en ce que les commandes électroniques pour les différents utilisateurs électriques du véhicule automobile sont rassemblées centralement sur la plaque de distributeur (10) dans un micro-ordinateur qui présente au moins un microprocesseur conçu comme un calculateur électronique avec au moins une mémoire de programmes ainsi qu'au moins une unité d'entrée et de sortie et des périphériques qui lui sont associés.

14. Boîtier électrique central selon une ou plusieurs des revendications 1 à 13, caractérisé en ce que des fiches plates (6) qui s'étendent à travers le fond (5) d'un boîtier (2) logeant le paquet de conducteurs (13) et la plaque support (14) dans un espace délimité par un rebord (7) formé sur le fond du boîtier (5) sont disposées pour le raccordement de faisceaux de câbles contre la plaquette inférieure de conducteurs plats (8) du paquet de conducteurs (13).

15. Boîtier électrique central selon une ou plusieurs des revendications 1 à 14, caractérisé en ce que le boîtier (2) est fermé au moyen d'un couvercle (20) recouvrant les fusibles à fiche plate (17) et les commutateurs (18) sur la plaque support (14).

16. Procédé pour la fabrication et le montage des barrettes de fil pour un boîtier électrique central selon une ou plusieurs des revendications 1 à 15, caractérisé en ce que la longueur et la hauteur des barrettes de fil sont d'abord déterminées au moyen d'un automate commandé par ordinateur en fonction de l'emplacement prévu des barrettes de fil (29) sur la plaque de distributeur (10), ensuite les barrettes de fil (29) sont cintrées et enfin montées sur la plaque de distributeur (10) et soudées au laser et/ou brasées.

**Fig. 1**

## Fig. 2

## Fig. 3

## Fig. 4

## Fig. 5

## Fig. 6

## Fig. 7

## Fig. 8

## Fig. 9

## Fig. 10

Fig. 11

Fig. 12

## Fig. 13

## Fig. 14

## Fig.15

## Fig. 16

Fig. 17

46

29

45

10

29 44 46 41 42

Fig. 18

44 29 46 29 45

46

29

46

29

42 46 10

## Fig.19

## Fig. 20